(19) Europäisches Patentamt / European Patent Office / Office européen des brevets

(11) **EP 4 296 586 B1**

(12) **EUROPEAN PATENT SPECIFICATION**

(45) Date of publication and mention
of the grant of the patent:
**09.04.2025 Bulletin 2025/15**

(21) Application number: **22180476.8**

(22) Date of filing: **22.06.2022**

(51) International Patent Classification (IPC):
**F24F 11/46** *(2018.01)* **G01R 22/10** *(2006.01)*

(52) Cooperative Patent Classification (CPC):
**G01R 22/10; F24F 11/46;** F24F 2140/60

(54) **SYSTEM AND METHOD FOR ESTIMATING ELECTRICAL POWER CONSUMPTION OF AN AIR-CONDITIONING SYSTEM**

SYSTEM UND VERFAHREN ZUM SCHÄTZEN DES VERBRAUCHS AN ELEKTRISCHEM STROM BEI EINER KLIMAANLAGE

SYSTÈME ET PROCÉDÉ D'ESTIMATION DE LA CONSOMMATION ÉLECTRIQUE D'UN SYSTÈME DE CLIMATISATION D'AIR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.12.2023 Bulletin 2023/52**

(73) Proprietor: **Robert Bosch GmbH**
**70442 Stuttgart (DE)**

(72) Inventors:
• **Cola, Fabrizio**
**534635 Singapur (SG)**
• **Tanyildiz, Baris**
**574036 Singapore (SG)**

(56) References cited:
**CN-A- 114 576 827    TW-B- I 592 617**
**US-A1- 2020 309 403**

**Description**

### TECHNICAL FIELD

The disclosure relates to a system and method for estimating energy consumption of an air-conditioning system, and in particular, a multi-part air-conditioning system.

### BACKGROUND

Electric power meters are commonly used to measure power consumption of air-conditioning systems or heating, ventilation, and air conditioning (HVAC) systems. However, where it is not possible to obtain power meter measurements, estimation of power metering may be used to inform users about system efficiency or providing energy management functions such as offgrid power supply management, battery management and tenant billing in distributed applications.

Various methods have been proposed to estimate power consumption of air-conditioning systems or units. One example uses one or more predefined power consumption lookup tables of HVAC running parameters that are based on laboratory test results. The running parameters are then used for choosing an approximate consumption value from a lookup table. CN 114 576 827 A discloses, in the context of determining the power utilization of an air-conditioner, the construction of a look-up table based on running parameters from both indoor and outdoor units.

Another example is the use of technical specification sheets associated with components such as compressor, fan motor, printed-circuit boards to predefine power consumption tables on component nominal running condition (i.e. compressor or fan motor running frequency / RPM information) to estimate approximate power consumption value. Such method is used for compact HVAC systems where the component behaviors are predictable or limited.

Another example uses the calculation of cooling/heating capacity and then calculating real-time power consumption of electricity consuming components such as compressor, fan motor, etc. by assuming operating conditions running at steady state.

Another example uses power circuit running conditions together with outdoor air temperature sensor to estimate approximate inverter power supply to motor, compressor and any other parts (i.e. heat sink).

Existing methods for estimating electrical power of air-conditioning system may not take into account actual field installation, varying operating conditions, aging of components, heat losses over time, faulty measurement devices, etc.

There exists a need for an improved method and system to alleviate at least one of the aforementioned problem(s).

### SUMMARY

The disclosure aims to minimize error of power estimation that is related with installation and/or running conditions of air-conditioning systems, such as HVAC system. A power meter may be used periodically to adjust or calibrate an estimation lookup table generated in the beginning of first running and then periodically during servicing or maintenance phases along the product lifecycle in the field. The generated lookup table may also be used to extrapolate/interpolate missing gaps in power meter readings, and may be used as a counter-check of the accuracy of the power meter in case an unacceptable deviation is detected.

According to the present disclosure there is a method for estimating electrical power consumption of an air-conditioning system according to claim 1. An air-conditioning system having incorporating an estimation of electrical power consumption is provided in claim 9. A computer program comprising instructions to execute the method is defined in claim 11.

The dependent claims define some examples associated with the method and air-conditioning system.

### BRIEF DESCRIPTION OF THE DRAWINGS

The disclosure will be better understood with reference to the detailed description when considered in conjunction with the non-limiting examples and the accompanying drawings, in which:

- FIG. 1 shows a schematic illustration of air-conditioning system, in accordance with various embodiments;
- FIG. 2 shows a flow chart of a method for estimating electrical energy consumption of an air-conditioning system, in accordance with various embodiments; and
- FIG. 3 shows an example lookup table for estimation of power consumption of an air-conditioning system according to the air-conditioning system of FIG. 1.
- FIG. 4 shows a flow chart of an example for creating a lookup table by varying the operation of the air-conditioning system under accelerated running conditions.
- FIG. 5 shows a general flow chart of a method for estimating electrical energy consumption of an air-conditioning system, in accordance with various embodiments.

## DETAILED DESCRIPTION

The following detailed description refers to the accompanying drawings that show, by way of illustration, specific details and embodiments in which the disclosure may be practiced. These embodiments are described in sufficient detail to enable those skilled in the art to practice the disclosure. Other embodiments may be utilized and structural, and logical changes may be made without departing from the scope of the disclosure. The various embodiments are not necessarily mutually exclusive, as some embodiments can be combined with one or more other embodiments to form new embodiments.

The disclosure illustratively described herein may suitably be practiced in the absence of any element or elements, limitation or limitations, not specifically disclosed herein. Thus, for example, the terms "comprising", "including," "containing", etc. shall be read expansively and without limitation. The word "comprise" or variations such as "comprises" or "comprising" will accordingly be understood to imply the inclusion of a stated integer or groups of integers but not the exclusion of any other integer or group of integers. Additionally, the terms and expressions employed herein have been used as terms of description and not of limitation, and there is no intention in the use of such terms and expressions of excluding any of the features shown and described or portions thereof, but it is recognized that various modifications are possible within the scope of the disclosure. Thus, it should be understood that although the present disclosure has been specifically described in exemplary embodiments and optional features, modification and variation of the disclosure embodied herein may be resorted to by those skilled in the art.

Features that are described in the context of an embodiment may correspondingly be applicable to the same or similar features in the other embodiments. Features that are described in the context of an embodiment may correspondingly be applicable to the other embodiments, even if not explicitly described in these other embodiments. Furthermore, additions and/or combinations and/or alternatives as described for a feature in the context of an embodiment may correspondingly be applicable to the same or similar feature in the other embodiments.

In the context of various embodiments, the articles "a", "an" and "the" as used with regard to a feature or element include a reference to one or more of the features or elements. As used herein, the term "and/or" includes any and all combinations of one or more of the associated listed items.

Throughout the description, the term "air-conditioning system", as used herein, may broadly refer to a system for providing temperature regulation and/or ventilation within an enclosed area, such as an enclosed room. It is contemplated that the term 'air-conditioning' includes at least one of heating, cooling, ventilating, humidifying, dehumidifying. The term 'multi-part air-conditioning system' includes at least an outdoor unit and at least one indoor unit, the at least one indoor unit used to regulate the temperature of an enclosed area. Multi-part air-conditioning system may include Variable Refrigerant Flow (VRF) systems. A VRF system may comprise one or more outdoor units and a plurality of indoor units that are connected using piping system, typically copper piping system, to the outdoor unit(s). VRF systems use electricity to run one or more compressors that are part of the outdoor units, to pressurize a refrigerant gas, which may be flowing between the indoor units and outdoor unit.

In VRF systems, one or more indoor units (IDUs) may be providing cooling capacity, corresponding to refrigerant flowing at a relatively low-pressure level, while other indoor unit(s) may be providing heating capacity, corresponding to refrigerant flowing at a relatively high-pressure level. Transition from a higherpressure level to a lower-pressure level may occur at the expansion valves, while the compressor is responsible for the refrigerant gas pressurization. Pressure sensors and temperature sensors may be placed at different points within the cycle to provide the necessary information as inputs to a central controller.

Throughout the description, the term "enclosed area", as used herein, may refer to a space between a floor and a ceiling that is enclosed on at least one side by solid walls or windows. For example, the enclosed area may be a part of or a division of a building enclosed by walls, floor, and ceiling, i.e. such as a room which may be enclosed on all sides. As a further example, the enclosed area may be enclosed on two or three sides, and may include enclosed areas such as a warehouse or a hangar.

Throughout the description, the term "running time", as used herein, may refer to a quantitative measure of the time interval during which the air-conditioning system is in a deployed operating state or condition after installation. This is contrasted to a laboratory testing condition which is referred to as "testing time".

Throughout the description, the term "processor", as used herein, may refer to one or more integrated circuit(s) operable to control one or more indoor units of the air-conditioning system. The processer may be a circuit and may include analog circuits or components, digital circuits or components, or hybrid circuits or components. Any other kind of implementation of the respective functions which will be described in more detail below may also be understood as a "circuit" in accordance with an alternative embodiment. A digital circuit may be understood as any kind of a logic implementing entity, which may be special purpose circuitry or a processor executing software stored in a memory, firmware, or any combination thereof. Thus, in various embodiments, a "circuit" may be a digital circuit, e.g. a hard-wired logic circuit or a programmable logic circuit such as a programmable processor, e.g. a microprocessor (e.g. a Complex Instruction Set Computer (CISC) processor or a Reduced Instruction Set Computer (RISC) processor). A "circuit" may also include a processor executing software, e.g. any kind of computer program, e.g. a computer program using a virtual machine code such as e.g. Java.

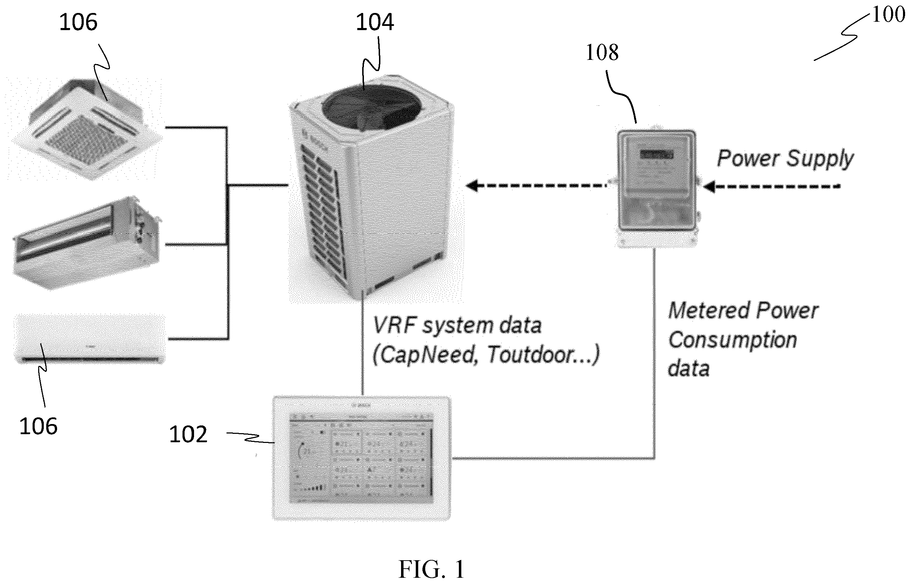

FIG. 1 shows an exemplary schematic illustration of an air-conditioning system 100. The air-conditioning system 100 may be a VRF system having a central controller 102, an outdoor unit 104, a plurality of indoor units 106. A power meter 108 may be arranged to obtain data measurements relating to the outdoor unit 104 and/or indoor units 106 and is arranged in signal or data communication with the central controller 102 to provide power consumption data thereto. The power meter 108 may be physically or remotely connected to the VRF system.

The central controller 102 may comprise at least one processor and input/output interface for receiving and transmitting data relating to the operation of the outdoor unit and/or indoor units.

The outdoor unit 104 may be a compressor unit configured to receive control signal from the central controller 102 and send operational or running sensor data to the central controller 102. The central controller 102 is also configured to direct refrigerant to each of the indoor unit(s) 106 to achieve the desired heat exchanging functions.

The indoor unit 106 may comprise ceiling mounted cassette type units and/or wall mounted indoor units.

The power meter 108 may include an intelligent power meter having wireless transmission capabilities.

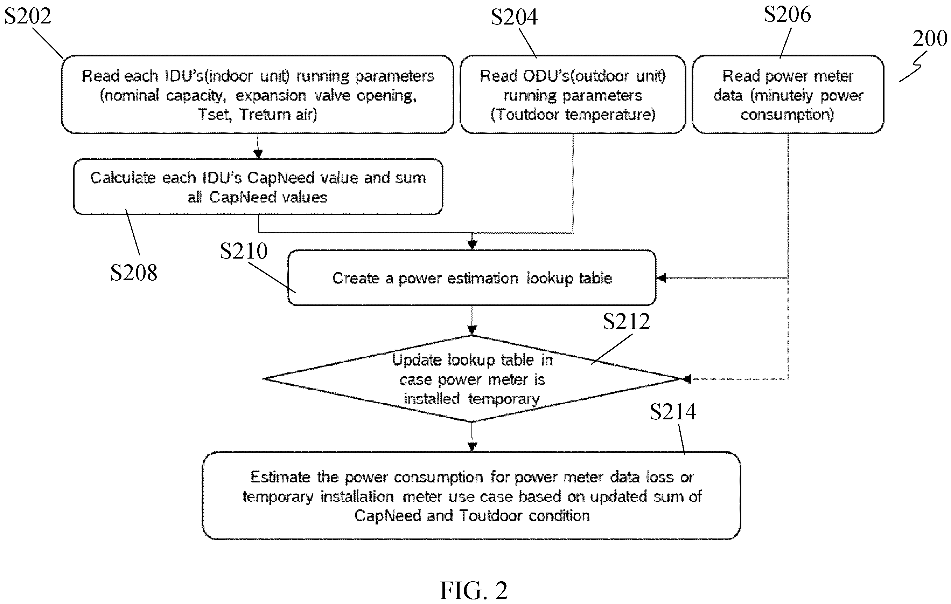

FIG. 2A is a flow chart illustrating the method 200 for estimating electrical power consumption of an air-conditioning system, such as the air-conditioning system 100 having a compressor and a plurality of indoor units (IDUs). The method 200 may comprise the steps of:

Step S202: reading each IDU's running parameters such as operating pressures, expansion valve opening in percentage or opening pulse value, set temperature in degree Celsius or degree Fahrenheit, and temperature of the return air in degree Celsius or degree Fahrenheit. The IDU running parameters may be obtained via sensors attached or connected at least one of the IDUs. The sensors may include temperature sensors, pressure sensors, and/or one or more sensors incorporated as part of the expansion valves, for example an electronic expansion valve.

Step S204: reading the outdoor unit (ODU) running parameters, including the outdoor temperature surrounding the ODU. The outdoor temperature readings may be obtained from one or more temperature sensors positioned around or in the vicinity of the ODU.

Step S206: reading the power meter data, which may be in the form of kilowatts (kW).

Step S208: calculating each IDU's capacity parameter. The capacity parameter may also be referred to as a CapNeed value and the sum of all CapNeed values may be referred to as a total CapNeed of all IDUs. In some embodiments, the calculation of the CapNeed parameter for each IDU may include the use of a comprehensive energy distribution algorithm to calculate the capacity (heating or cooling) generated by each indoor unit (IDU) of a VRF system, of both standard (2-pipe) and heat recovery type (3-pipe), to accurately estimate the ratio of outdoor unit (ODU) energy consumption associated with each IDU.

Step S210: creating a power estimation lookup table. The lookup table may be in the form of a database having entries correlating the power meter data with the CapNeed value(s) of the IDUs with the outdoor parameters of the ODU.

Step S212: where the power meter is a temporary installation, update the lookup table created in step S210 as and when required (ad hoc), or in accordance with a maintenance schedule.

Step S214: estimate the power consumption for any power meter data loss or temporary installation meter use case based on updated total CapNeed of all IDUs and the outdoor parameter.

In some embodiments, steps S202 to S210 may be associated with a first installation state of the air-conditioning system, and steps S212 and S214 may be associated with a maintenance or servicing state. Such maintenance state may be ad-hoc or scheduled.

The power meter 108 may be a power meter permanently connected to the air-conditioning system 100, or may be a temporary power meter connected to the air-conditioning system 100 whenever required for maintenance or servicing.

In an example where the power meter is permanently connected, the lookup table may be used as an estimator in case of data interruption or loss arising for faulty connections or faulty meters in operation. In such an example, the lookup table may be used to interpolate or extrapolate the missing values, for example the CapNeed or outdoor temperature values. In addition, the power meter may also be used for periodic calibration or update of the lookup table to account for improper installation of either one of the IDU or ODU, recent operating conditions and wear and tear and aging equipment that may result through extended operation.

In an example where the power meter is temporarily connected during maintenance or operation, the power meter may be used to re-calibrate the lookup table to account for recent operating conditions as well as wear and tear, aging equipment that may result through extended operation.

In some embodiments, the method 200 may be executed by the central controller 102. In this regard, the central controller 102 may include one or more computers installed with a computer program comprising instructions which, when the computer program is executed by the one or more computers, cause the one or more computers to execute the method 200.

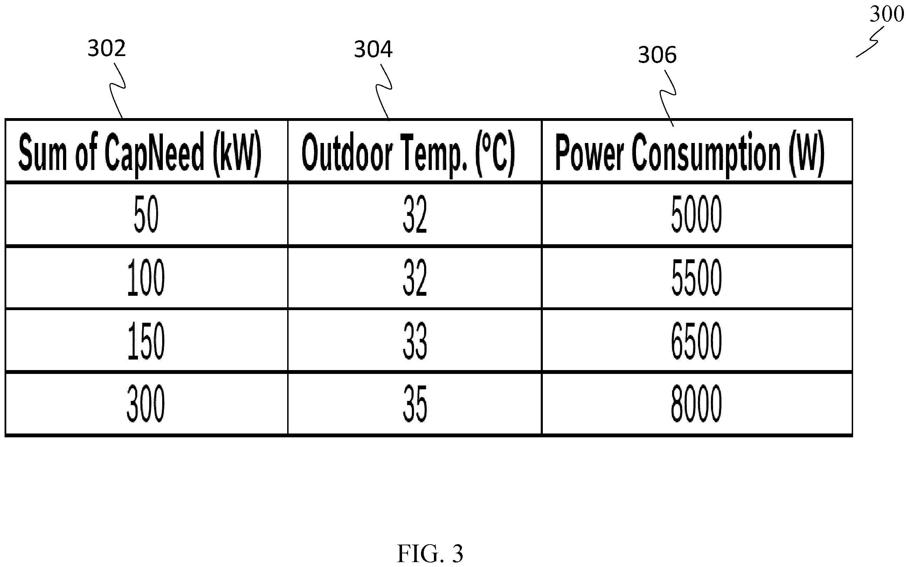

FIG. 3 shows an example of a lookup table 300. It is contemplated that the lookup table may be implemented in the form of a computer database. The lookup table 300 is organized in the form of correlation between sum of CapNeed for all indoor units, for example 10 indoor units, as shown in column 302, the temperature surrounding the ODU (also known as the outdoor temperature) as shown in column 304, and the power consumption shown in column 306. The lookup table 300 is initially generated after first installation and the power consumption entries populated using a power meter connected to the air-conditioning system. The power consumption entries may be updated or revised during every maintenance or servicing cycle, where a power meter is utilized for re-calibration or cross-checking.

In some embodiments, the capacity parameter in the form of a CapNeed function to calculate required/needed capacity of each indoor unit may be expressed as follows:

$$f\ (CapNeed)\ =\ (indoor\ unit\ nominal\ capacity\ x\ K*expansion\ valve\ opening\ value\ x$$
$$DeltaT\ (return\ air - set\ temp))$$

$$(1)$$

(1) where the indoor unit nominal capacity may be obtained from technical specifications or datasheet. The expansion valve opening value may be expressed as a percentage, the delta T temperature value may be a temperature difference between the return air temperature and the set temperature.

As an example, the following parameters may be used

    a. Sample indoor unit nominal capacity: 10 kW
    b. Expansion valve opening value: 50%
    c. DeltaT (Return air - Set temperature): +2°C
    d. CapNeed value: 4 kW (assuming coefficient of expansion valve K is 0.4)

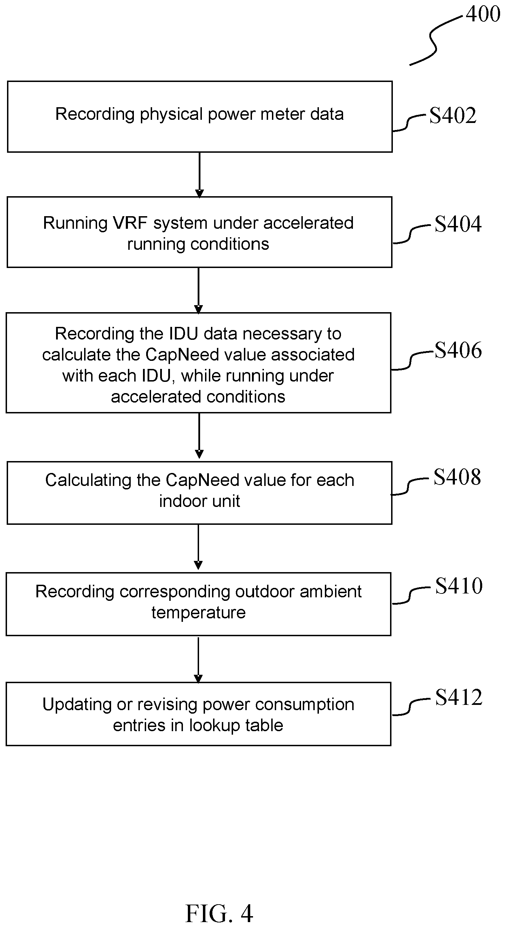

In some embodiments as shown in FIG. 4, the method for building a power estimation lookup table includes the steps of:

Step S402- recording physical power meter data. The power meter data may be obtained every few seconds, every few minutes, or other intervals as predetermined.

Step S404- running VRF system under accelerated running conditions. The VRF system may be configured to run at minimum (i.e. one IDU corresponding to the lowest power consumption unit), followed by 50% of all IDUs, and then 100% of all IDUs. For example, in an air-conditioning system having four IDUs and one ODU, the IDUs with the smallest power capacity will be set to run for a first predetermined period, followed by two IDUs for a second pre-determined period, three IDUs for a first pre-determined period, and all four IDUs for a fourth pre-determined period. In some embodiments, two or more of the aforementioned pre-determined periods may be the same.

Step S406- recording the IDU data necessary to calculate the CapNeed value associated with each IDU, while running under accelerated conditions. The CapNeed value may be calculated based on Equation (1).

Step S408- The CapNeed value is calculated based on each indoor unit's nominal capacity, expansion valve opening value, room temperature and evaporator temperature, so the actual load of each indoor unit will be calculated and translated to indoor unit capacity factor. Sum of all indoor unit's capacity factor will be the total CapNeed value.

Step S410- The corresponding outdoor ambient temperature under accelerated running conditions is also recorded obtained every few seconds, every few minutes, or other intervals as pre-determined.

Step S412- Update estimation lookup table periodically once power meter is integrated/installed again, check any deviation or drift of previous version of lookup table. In some embodiments, the deviation or drift may be accompanied by one or more notifications or alarm.

It is appreciable steps S406 and S408 may be performed concurrently, and/or their order may be reversed.

In embodiments where the power meter is permanently installed, the recording of power consumption measurements may be used to update the estimation lookup table periodically based on the total CapNeed value and outdoor ambient temperature.

In case data acquisition loss associated with the power meter is detected, historical records, for example, a past week data, may be used to estimate the current loss power metering values based on finding a match between a total CapNeed value and outdoor ambient temperature conditions. If no matching CapNeed value was found, then interpolation, extrapolation or other statistical methods may be used to generate an estimated CapNeed value with the corresponding power consumption value. It is appreciated that the detection of data acquisition loss may be triggered by an interruption of data logging, any out of range data or abnormal readings, or the absence of heartbeat signals configured to be sent by the power meter to the central controller periodically. In some embodiments, if the missing power meter value is below a predetermined time frame, for example, not longer than one hour, the above historical records may be used.

In some embodiments, additional running parameters of one or more indoor units may be obtained and/or calculated. The running parameters may include pressure levels calculation, mass flow rate distribution, enthalpy calculation and capacity calculation and distribution.

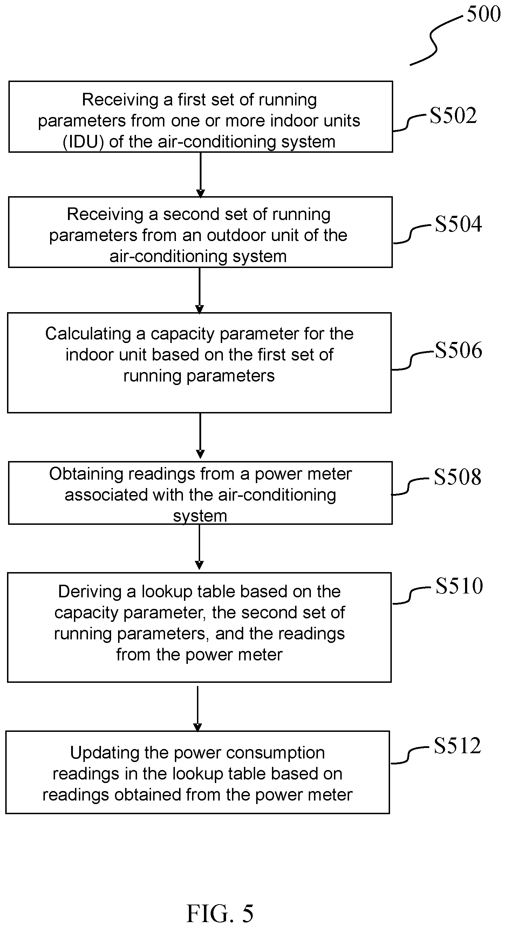

FIG. 5 shows a generic flow chart of a method 500 for estimating electrical power consumption of an air-conditioning system having at least one IDU and at least one ODU. It is envisaged the method 500 may be applied to different types of air-conditioning systems.

Step S502- receiving a first set of running parameters from one or more indoor units (IDU) of the air-conditioning system;

Step S504- receiving a second set of running parameters from an outdoor unit of the air-conditioning system;

Step S506- calculating a capacity parameter for the indoor unit based on the first set of running parameters;

Step S508- obtaining readings from a power meter associated with the air-conditioning system;

Step S510- deriving a lookup table based on the capacity parameter, the second set of running parameters, and the readings from the power meter; and

Step S512- updating the power consumption readings in the lookup table based on readings obtained from the power meter.

It is envisaged steps S502 to S5510 may be performed at a first installation of the air-conditioning system to generate a lookup table, and step S512 may be performed at a state after the first installation, such state may correspond to maintenance or servicing state triggered by a pre-determined schedule or ondemand.

It is appreciable steps S502, S504 and S508 may be performed concurrently. Alternatively, the order of steps may be changed. For example, step S508 may be performed before steps S502 and/or S504.

While the disclosure has been particularly shown and described with reference to specific embodiments, it should be understood by those skilled in the art that various changes in form and detail may be made therein without departing from the scope of the disclosure as defined by the appended claims. The scope of the disclosure is thus indicated by the appended claims and all changes which come within the meaning and range of the claims are therefore intended to be embraced.

## Claims

1. A method (500) for estimating electrical power consumption of an air-conditioning system comprising the steps of:

   at a first installation of the air-conditioning system:

   (a.) receiving a first set of running parameters from an indoor unit of the air-conditioning system (S502);
   (b.) receiving a second set of running parameters from an outdoor unit of the air-conditioning system (S504);
   the method **characterised by**:
   (c.) calculating a capacity parameter of the indoor unit based on the first set of running parameters (S506);
   (d.) obtaining power consumption readings from a power meter associated with the air-conditioning system (S508);
   (e.) deriving a lookup table based on the capacity parameter, the second set of running parameters, and the power consumption readings from the power meter (S510); and

   at a time after operating the air-conditioning system:
   (f.) updating the power consumption readings in the lookup table based on readings obtained from the power meter (S512).

2. The method of claims 1, wherein the first set of running parameters comprise an expansion valve opening value, and a temperature difference between a set temperature and a temperature of a return air.

3. The method of claim 2, wherein the capacity parameter of the indoor unit is calculated based on the running parameters and a nominal capacity value of the indoor unit.

4. The method of any one of the preceding claims, further comprising a step of removing the power meter after step (d.) and attaching another power meter or the power meter at step (f.).

**5.** The method of any one of the preceding claims, further comprising a step of detecting one or more missing power consumption readings associated with the power meter, wherein upon detection of the one or more missing power consumption readings, further comprising a step of checking if there is a corresponding capacity parameter match in the lookup table.

**6.** The method of claim 5, wherein if a corresponding capacity parameter match is not found in the lookup table, further comprising the step of extrapolating or interpolating the one or more missing power consumption readings and the capacity parameter, and entering the extrapolated or interpolated values into the lookup table.

**7.** The method of claim 6, further comprising the step of re-calibrating the lookup table and the extrapolated or interpolated values in the lookup table when the power meter is able to measure readings associated with the one or more missing power consumption readings.

**8.** The method of any one of the preceding claims, wherein the air-conditioning system is a Variable Refrigerant Flow (VRF) system comprising an outdoor unit and a plurality of indoor units.

**9.** An air-conditioning system (100) having an indoor unit (106), an outdoor unit (104), one or more sensors positioned in the vicinity of the indoor unit (106) and/or the outdoor unit (104) to obtain running parameters of the indoor unit and the outdoor unit, and a processor (102) arranged in data communication with the one or more sensors to determine or receive a signal indicating whether the air-conditioning system (100) is in an installation state or an operating state; wherein

if the air-conditioning system is in the installation state, the processor (102) is configured to

    (a.) receive a first set of running parameters from the indoor unit (106);
    (b.) receive a second set of running parameters from the outdoor unit (104); **characterised by** the processor being configured to:
    (c.) calculate a capacity parameter of the indoor unit based on the first set of running parameters;
    (d.) obtain power consumption readings from a power meter (108) associated with the air-conditioning system;
    (e.) derive a lookup table (300) based on the capacity parameter, the second set of running parameters, and the power consumption readings from the power meter; and

if the air-conditioning system is in the operating state, upon receiving a signal to update the lookup table, the processor is configured to update the power consumption readings in the lookup table based on readings obtained from the power meter.

**10.** The air-conditioning system of claim 9, wherein the air-conditioning system is a Variable Refrigerant Flow (VRF) system comprising an outdoor unit and a plurality of indoor units.

**11.** A computer program comprising instructions which, when the program is executed by a computer, cause the computer to carry out the steps as defined in any one of claims 1 to 8.


**Patentansprüche**

**1.** Verfahren (500) zum Schätzen des Verbrauchs von elektrischer Energie eines Klimatisierungssystems, das die folgenden Schritte umfasst:

bei einer ersten Installation des Klimatisierungssystems:

    (a.) Empfangen einer ersten Gruppe von Betriebsparametern von einer Innenraumeinheit des Klimatisierungssystems (S502);
    (b.) Empfangen einer zweiten Gruppe von Betriebsparametern von einer Außeneinheit des Klimatisierungssystems (S504); wobei das Verfahren **gekennzeichnet ist durch**:
    (c.) Berechnen eines Kapazitätsparameters der Innenraumeinheit auf der Grundlage der ersten Gruppe von Betriebsparametern (S506);
    (d.) Erhalten von Energieverbrauchsmesswerten von einer Energiemesseinrichtung, die dem Klimatisierungssystem zugeordnet ist (S508);
    (e.) Ableiten einer Nachschlagetabelle auf der Grundlage des Kapazitätsparameters, der zweiten Gruppe von Betriebsparametern und der Energieverbrauchsmesswerte von der Energiemesseinrichtung (S510); und

zu einer Zeit nach dem Betreiben des Klimatisierungssystems:
(f.) Aktualisieren der Energieverbrauchsmesswerte in der Nachschlagetabelle auf der Grundlage von Messwerten, die von der Energiemesseinrichtung erhalten werden (S512).

2. Verfahren nach Anspruch 1, wobei die erste Gruppe von Betriebsparametern einen Entspannungsventil-Öffnungswert und eine Temperaturdifferenz zwischen einer eingestellten Temperatur und einer Temperatur einer Rückstromluft umfasst.

3. Verfahren nach Anspruch 2, wobei der Kapazitätsparameter der Innenraumeinheit auf der Grundlage der Betriebsparameter und eines Nennkapazitätswertes der Innenraumeinheit berechnet wird.

4. Verfahren nach einem der vorhergehenden Ansprüche, das ferner einen Schritt des Entfernens der Energiemesseinrichtung nach Schritt (d.) und des Anbringens einer weiteren Energiemesseinrichtung oder der Energiemesseinrichtung in Schritt (f.) umfasst.

5. Verfahren nach einem der vorhergehenden Ansprüche, das ferner einen Schritt des Detektierens eines oder mehrerer fehlender Energieverbrauchsmesswerte, die der Energiemesseinrichtung zugeordnet sind, umfasst, wobei es bei Detektion des einen oder der mehreren fehlenden Energieverbrauchsmesswerte ferner einen Schritt des Prüfens, ob es eine Übereinstimmung eines entsprechenden Kapazitätsparameters in der Nachschlagetabelle gibt, umfasst.

6. Verfahren nach Anspruch 5, wobei es dann, wenn in der Nachschlagetabelle keine Übereinstimmung eines entsprechenden Kapazitätsparameters gefunden wird, den Schritt des Extrapolierens oder Interpolierens des einen oder der mehreren fehlenden Energieverbrauchsmesswerte und des Kapazitätsparameters und des Eingebens der extrapolierten oder interpolierten Werte in die Nachschlagetabelle umfasst.

7. Verfahren nach Anspruch 6, das ferner den Schritt des Neukalibrierens der Nachschlagetabelle und der extrapolierten oder interpolierten Werte in der Nachschlagetabelle, wenn die Energiemesseinrichtung Messwerte messen kann, die dem einen oder den mehreren fehlenden Energieverbrauchsmesswerten zugeordnet sind, umfasst.

8. Verfahren nach einem der vorhergehenden Ansprüche, wobei das Klimatisierungssystem ein System mit veränderlichem Kühlmitteldurchfluss (VRF-System) ist, das eine Außeneinheit und mehrere Innenraumeinheiten umfasst.

9. Klimatisierungssystem (100), das eine Innenraumeinheit (106), eine Außeneinheit (104), einen oder mehrere Sensoren, die in der Umgebung der Innenraumeinheit (106) und/oder der Außeneinheit (104) angeordnet sind, um Betriebsparameter der Innenraumeinheit bzw. der Außeneinheit zu erhalten, und einen Prozessor (102), der in Datenkommunikation mit dem einen oder den mehreren Sensoren angeordnet ist, um ein Signal zu bestimmen oder zu empfangen, das angibt, ob sich das Klimatisierungssystem (100) in einem Installationszustand oder einem Arbeitszustand befindet, umfasst; wobei dann, wenn sich das Klimatisierungssystem im Installationszustand befindet, der Prozessor (102) konfiguriert ist zum

(a.) Empfangen einer ersten Gruppe von Betriebsparametern von der Innenraumeinheit (106);
(b.) Empfangen einer zweiten Gruppe von Betriebsparametern von der Außeneinheit (104); **dadurch gekennzeichnet, dass** der Prozessor konfiguriert ist zum:
(c.) Berechnen eines Kapazitätsparameters der Innenraumeinheit auf der Grundlage der ersten Gruppe von Betriebsparametern;
(d.) Erhalten von Energieverbrauchsmesswerten von einer Energiemesseinrichtung (108), die dem Klimatisierungssystem zugeordnet ist;
(e.) Ableiten einer Nachschlagetabelle (300) auf der Grundlage des Kapazitätsparameters, der zweiten Gruppe von Betriebsparametern und der Energieverbrauchsmesswerte von der Energiemesseinrichtung; und

dann, wenn sich das Klimatisierungssystem im Arbeitszustand befindet, der Prozessor aufgrund des Empfangens eines Signals, die Nachschlagetabelle zu aktualisieren, konfiguriert ist, die Energieverbrauchsmesswerte in der Nachschlagetabelle auf der Grundlage von Messwerten, die von der Energiemesseinrichtung erhalten werden, zu aktualisieren.

**10.** Klimatisierungssystem nach Anspruch 9, wobei das Klimatisierungssystem ein System mit veränderlichem Kühlmitteldurchfluss (VRF-System) ist, das eine Außeneinheit und mehrere Innenraumeinheiten umfasst.

**11.** Computerprogramm, das Anweisungen umfasst, die dann, wenn das Programm durch einen Computer ausgeführt wird, bewirken, dass der Computer die Schritte, wie in einem der Ansprüche 1 bis 8 definiert, ausführt.

**Revendications**

**1.** Procédé (500) d'estimation de la consommation d'énergie électrique d'un système de climatisation d'air comprenant les étapes consistant à :

au niveau d'une première installation du système de climatisation d'air :

(a.) la réception d'un premier ensemble de paramètres de fonctionnement en provenance d'une unité d'intérieur du système de climatisation d'air (S502) ;
(b.) la réception d'un deuxième ensemble de paramètres de fonctionnement en provenance d'une unité d'extérieur du système de climatisation d'air (S504) ; le procédé **caractérisé par** :
(c.) le calcul d'un paramètre de capacité de l'unité d'intérieur sur la base du premier ensemble de paramètres de fonctionnement (S506) ;
(d.) l'obtention de relevés de consommation d'énergie en provenance d'un mesureur de puissance associé au système de climatisation d'air (S508) ;
(e.) la dérivation d'une table de consultation sur la base du paramètre de capacité, du deuxième ensemble de paramètres de fonctionnement, et des relevés de consommation d'énergie en provenance du mesureur de puissance (S510) ; et

à un moment après l'utilisation du système de climatisation d'air :
(f.) la mise à jour des relevés de consommation d'énergie dans la table de consultation sur la base de relevés obtenus en provenance du mesureur de puissance (S512).

**2.** Procédé selon la revendication 1, dans lequel le premier ensemble de paramètres de fonctionnement comprend une valeur d'ouverture de soupape de détente, et une différence de température entre une température de consigne et une température d'un air de retour.

**3.** Procédé selon la revendication 2, dans lequel le paramètre de capacité de l'unité d'intérieur est calculé sur la base des paramètres de fonctionnement et d'une valeur de capacité nominale de l'unité d'intérieur.

**4.** Procédé selon l'une quelconque des revendications précédentes, comprenant en outre une étape consistant à retirer le mesureur de puissance après l'étape (d.) et à attacher un autre mesureur de puissance ou le mesureur de puissance au niveau de l'étape (f.).

**5.** Procédé selon l'une quelconque des revendications précédentes, comprenant en outre une étape consistant à détecter un ou plusieurs relevés de consommation d'énergie manquants associés au mesureur de puissance, dans lequel à détection des un ou plusieurs relevés de consommation d'énergie manquants, comprenant en outre une étape consistant à vérifier s'il y a un appariement de paramètres de capacité correspondants dans la table de consultation.

**6.** Procédé selon la revendication 5, dans lequel si un appariement de paramètres de capacité correspondants n'est pas trouvé dans la table de consultation, comprenant en outre l'étape consistant à extrapoler ou interpoler les un ou plusieurs relevés de consommation d'énergie manquants et le paramètre de capacité, et à entrer des valeurs extrapolées ou interpolées dans la table de consultation.

**7.** Procédé selon la revendication 6, comprenant en outre l'étape consistant à ré-étalonner la table de consultation et les valeurs extrapolées ou interpolées dans la table de consultation lorsque le mesureur de puissance est capable de mesurer des relevés associés aux un ou plusieurs relevés de consommation d'énergie manquants.

**8.** Procédé selon l'une quelconque des revendications précédentes, dans lequel le système de climatisation d'air est un système de débit de fluide frigorigène variable (VRF) comprenant une unité d'extérieur et une pluralité d'unités d'intérieur.

9.  Système de climatisation d'air (100) ayant une unité d'intérieur (106), une unité d'extérieur (104), un ou plusieurs capteurs positionnés à proximité de l'unité d'intérieur (106) et/ou de l'unité d'extérieur (104) pour obtenir des paramètres de fonctionnement de l'unité d'intérieur et de l'unité d'extérieur, et un processeur (102) agencé en communication de données avec les un ou plusieurs capteurs pour déterminer ou recevoir un signal indiquant si le système de climatisation d'air (100) est dans un état d'installation ou dans un état d'utilisation ; dans lequel

si le système de climatisation d'air est dans l'état d'installation, le processeur (102) est configuré pour

(a.) recevoir un premier ensemble de paramètres de fonctionnement en provenance de l'unité d'intérieur (106) ;
(b.) recevoir un deuxième ensemble de paramètres de fonctionnement en provenance de l'unité d'extérieur (104) ; **caractérisé en ce que** le processeur est configuré pour :
(c.) calculer un paramètre de capacité de l'unité d'intérieur sur la base du premier ensemble de paramètres de fonctionnement ;
(d.) obtenir des relevés de consommation d'énergie en provenance d'un mesureur de puissance (108) associé au système de climatisation d'air ;
(e.) dériver une table de consultation (300) sur la base du paramètre de capacité, du deuxième ensemble de paramètres de fonctionnement, et des relevés de consommation d'énergie en provenance du mesureur de puissance ; et

si le système de climatisation d'air est dans l'état de fonctionnement, à réception d'un signal pour mettre à jour la table de consultation, le processeur est configuré pour mettre à jour les relevés de consommation d'énergie dans la table de consultation sur la base de relevés obtenus en provenance du mesureur de puissance.

10. Système de climatisation d'air selon la revendication 9, dans lequel le système de climatisation d'air est un système de débit de fluide frigorigène variable (VRF) comprenant une unité d'extérieur et une pluralité d'unités d'intérieur.

11. Programme d'ordinateur comprenant des instructions qui, lorsque le programme est exécuté par un ordinateur, amènent l'ordinateur à effectuer les étapes telles que définies dans l'une quelconque des revendications 1 à 8.

FIG. 1

EP 4 296 586 B1

FIG. 2

| Sum of CapNeed (kW) | Outdoor Temp. (°C) | Power Consumption (W) |
|---|---|---|
| 50 | 32 | 5000 |
| 100 | 32 | 5500 |
| 150 | 33 | 6500 |
| 300 | 35 | 8000 |

FIG. 3

400

Recording physical power meter data — S402

Running VRF system under accelerated running conditions — S404

Recording the IDU data necessary to calculate the CapNeed value associated with each IDU, while running under accelerated conditions — S406

Calculating the CapNeed value for each indoor unit — S408

Recording corresponding outdoor ambient temperature — S410

Updating or revising power consumption entries in lookup table — S412

FIG. 4

500

Receiving a first set of running parameters from one or more indoor units (IDU) of the air-conditioning system — S502

Receiving a second set of running parameters from an outdoor unit of the air-conditioning system — S504

Calculating a capacity parameter for the indoor unit based on the first set of running parameters — S506

Obtaining readings from a power meter associated with the air-conditioning system — S508

Deriving a lookup table based on the capacity parameter, the second set of running parameters, and the readings from the power meter — S510

Updating the power consumption readings in the lookup table based on readings obtained from the power meter — S512

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• CN 114576827 A